# EUROPEAN PATENT SPECIFICATION

(11) **EP 0 852 399 B1**
(45) Date of publication and mention of the grant of the patent: **22.10.2008**
(21) Application number: 97100010.4
(22) Date of filing: 02.01.1997
(51) Int. Cl.: H01L 23/427

(54) **Semiconductor element cooling apparatus**
Halbleiterelement mit Kühlvorrichtung
Elément semi-conducteur ayant un dissipateur de chaleur

(43) Date of publication of application: 08.07.1998
(73) Proprietor: Sumitomo Precision Products Co., Ltd., Hyogo 660 (JP)
(72) Inventor: Kitani, Kazuo, Sumitomo Precision Prod. Co., Ltd., Amagasaki-shi, Hyogo 660 (JP); Ando, Kenji, Sumitomo Precision Products Co., Ltd., Amagasaki-shi, Hyogo 660 (JP)
(74) Representative: Wächtershäuser, Günter

(56) References cited:
- EP-A- 0 310 039
- US-A- 3 989 099
- US-A- 4 574 877
- PATENT ABSTRACTS OF JAPAN vol. 006, no. 251 (E-147), 10 December 1982 & JP 57 152150 A (SHIYOUWA ARUMINIUMU KK), 20 September 1982,
- PATENT ABSTRACTS OF JAPAN vol. 016, no. 554 (E-1293), 25 November 1992 & JP 04 211151 A (FUJI ELECTRIC CO LTD), 3 August 1992,
- PATENT ABSTRACTS OF JAPAN vol. 096, no. 012, 26 December 1996 & JP 08 204075 A (SUMITOMO PRECISION PROD CO LTD;TOSHIBA CORP)

## Description

### DETAILED DESCRIPTION OF THE INVENTION

### Industrial Application Field

The present invention relates generally to a semiconductor element cooling apparatus of a non-dipping ebullition type for respectively cooling a plurality of semiconductor elements simultaneously with the use of the ebullition of refrigerants.

### Prior Art

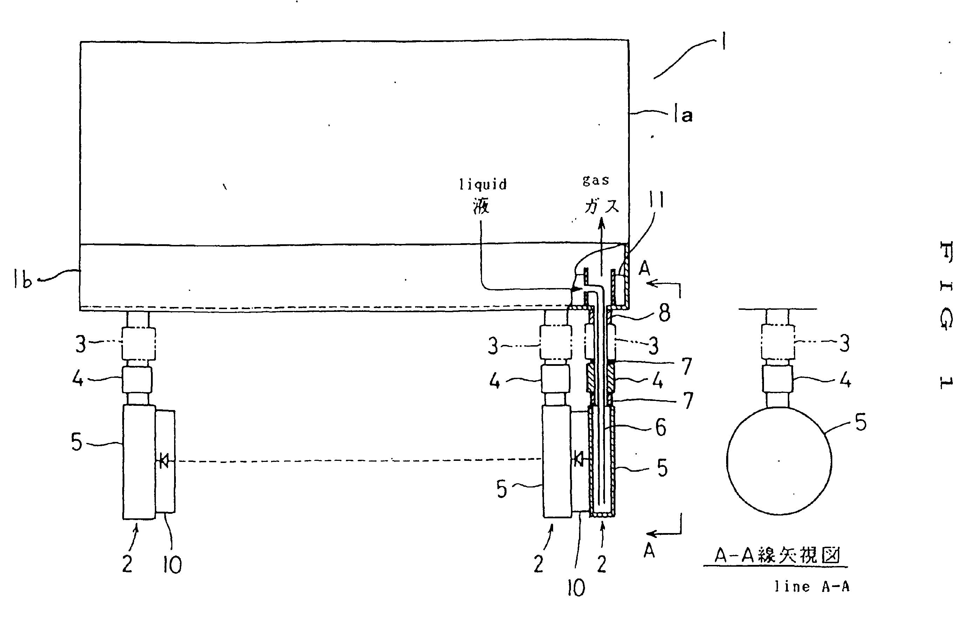

Many semiconductor elements of mass capacity are used for converter apparatuses or inverter apparatuses for controlling motors for rolling stock. There is such a non-dipping ebullition type of cooling apparatus as shown in Fig. 1, as an apparatus for individually cooling many mass capacity semiconductor elements at the same time.

The cooling apparatus is composed of a condenser 1 with a bottom portion tank 1b being mounted downwards of a heat exchanger 1a, and a plurality of cooling fins 2, 2, ... mounted at given intervals on the bottom portion tank 2. Each cooling fin 2, where a bellows 3, an insulating tube 4, an ebullition portion 5 are connected from top to bottom, is provided to cool with refrigerants 11 the semiconductor element 10 arranged between adjacent ebullition portions 5, 5.

Namely, the refrigerants which are cooled by the heat exchanger 1a of the condenser 1 into liquid stay once in the bottom portion tank 1b. The refrigerant 11 (liquid) within the bottom portion tank 1b is introduced into the ebullition portion 5 of the cooling fin 2 through the return tube 6 extending through the cooling fin 2. The semiconductor element 10 is cooled by boiling of refrigerant 11 (liquid) within the ebullition portion 5 by heating of the semiconductor element 10. The refrigerant evaporated by the ebullition returns into the bottom portion tank 1b of the condenser 1 through the insulating pipe 4, the bellows 3, and is liquified again in the heat exchanger 1a located on it to stay within the bottom portion tank 1b.

cylindrical dam 1c is provided, corresponding to each cooling fine 2, within the bottom portion tank 1b to prevent mixing between the liquid of the refrigerant 11 and the gas within the bottom portion tank 1b. The inner side of the dam 1c is a gas portion, while the outer side thereof is a liquid portion. Each cooling fin 2 is communicated with the inner side of the dam 11c, namely, the gas portion within the bottom portion tank 1b, while the return tube 6 within the cooling fin 2 is communicated with the liquid portion on the outer side of the dam 1c.

The ebullition portion 5 is composed of a copper-made cell with compartment walls provided therein to form a plurality of refrigerant passages being formed to maintain thermal transmission high, and the inner face of the refrigerant passage is uneven due to blast-treated for boiling promotion. Also, an insulating, tube 4 indispensable for electric insulation of the semiconductor element 10 is composed of a ceramic tube. The bellows 3 is required to widen the interval by moving of the ebullition portion 5 in the mounting of the semiconductor element 10. Conventionally, a stainless steel tube of bellows construction is used US Patent 3 989 099 discloses a semiconductor element cooling apparatus of the refrigerant ebullition type.

### Problem to be Solved by the Invention

Such a conventional non-dipping ebullition type of semiconductor element cooling apparatus has such problems in the cooling fin.

The ebullition portion 5, made of copper, increases in weight, thus preventing the cooling apparatus from becoming lighter. The working operation requires much labor, increasing in cost, because a cutting operation is required for manufacturing, and a blast-treating operation is used for uneven inner face.

Much labor is necessary for assembling, because soldering (silver solder) is used for splicing of each member. The soldering is required with expensive high alloy coupling 7 like 42% NI - Fe being interposed between the insulating tube 4 and the ebullition tube 5, because the splicing between the ceramic and the copper is difficult to effect when the silver solder is used. Similarly, a high alloy coupling 7 is required to be interposed even between the bellows 3 composed of stainless steel, and the insulating tube 4.

A foreign material coupling 8 made of aluminum and stainless steel is interposed between the condenser 1 and the bellows 3 because of difficult soldering of the aluminum and the stainless steel although aluminum is used to reduce the weight as the components of the condenser 1. The number of the components are many because of use of many couplings and sorts.

The splicing between them requires such soldering as described above although simple TIG welding can be used in the splicing of this portion because the splicing between the stainless steel and the aluminum is replaced by the splicing between the aluminum and aluminum when the foreign material coupling 8 is used.

An object of the invention is to provide a semiconductor element cooling apparatus lower in manufacturing cost, fewer in component number, easier in manufacturing assembling, and lighter due to manufacturing with aluminum except for a few portions of the insulating portion and so on of the cooling fin.

### Means for Solving the Problem

The semiconductor element cooling apparatus of the invention is described in claim 1. It is a refrigerant ebullition type of semiconductor element cooling apparatus, comprising a condenser provided with an aluminum-made bottom portion tank for storing the refrigerant liquid downwards of an aluminum-made heat exchanger, a plurality of cooling fins mounted at given intervals on the bottom portion tank of the condenser and adapted to be communicated with the gas portion of the bottom portion tank, a return tube to be inserted into each cooling fin from the liquid portion within the bottom portion tank, wherein heating of the semiconductor elements disposed among the respective cooling fins is robbed by the boiling of the refrigerant liquid to be introduced by cooling fins from the condenser to return refrigerant gases caused by the boiling to the condenser to liquefy them.

The cooling fin is provided with an ebullition portion made of aluminum, an insulating portion interposed between the ebulliton portion and the condenser, the insulating portion being provided with peripheral grooves on the inner face and the outer face to give flexibility to the aluminum tube with an aluminum tube being spliced in both the ends of the ceramic tube.

The semiconductor element cooling apparatus of the invention can construct the portion, except for the ceramic tube within the insulating portion of the return tube and the cooling fins.

Also, the aluminum-made ebullition portion is not only light in weight, but also can be formed by extruding. The extruding makes it possible to form refrigerant passages by provision of the fins in given intervals within the ebullition portion and to effect an uneven working operation for promoting the boiling on the surfaces of the refrigerant passages. The uneven working operation can be effected by knurling working at the same time with the extruding molding. Therefore, cooling fins light in weight and higher in performance can be made at lower price.

The insulating portion functions as a foreign material coupling for splicing an aluminum-made condenser with a ebullition portion, because the insulating portion has an aluminum tube on both the end sides of the ceramic tube. Also, the aluminum tube functions as bellows and is light in weight, because the aluminum tube is flexible, thus contributing towards reduction in number of parts. Also, an easier splicing operation can be effected with TIG welding with respect to the condenser and to the ebullition portion. The sliding between the ceramic tube and the aluminum tube in the insulating portion does not need the high alloy coupling, because direct splicing can be effected by the aluminum soldering, different in splicing between the ceramic and the copper.

The return tube is preferable to use the insulating material to prevent the electric short with respect to the ebullition portion. Especially the preferable resin is PTFE. As the insulating material, fluorine resin is desirable such as PTFE (tetrafluoride ethylene resin), FEP (tetrafluoride ethylene - hexafluoride propylene copolymerized resin), PFA (tetrafluoride ethylene - phloroalkyl vinyl ether copolymerized resin), ETFE (tetrafluoride ethylene - ethylen copolymerized resin), CTFE (trifluoride chloride ethylen resin), PVDF (vinylidene fluoride), PVF (polyvinyl fluoride), E-CTFE (trifluoride chloride ethylen - ethylen copolymerized resin) or the like.

The construction of the ebullition portion is desirably composed of a square cylindrical main body which is made of aluminum extruding mold material where the refrigerant flows on the inner side in a vertical direction, and an upper, lower cover bodies for closing the upper, lower opening portion of the main body. The square cylindrical main body is preferable to be partitioned into a plurality of refrigerant passages with a plurality of fins arranged in lateral width direction, except for at least the upper end portion and the lower end portion. Such a main body, superior in heat transfer property, can be manufactured at lower price by extruding. The fins from the upper end portion and the lower end portion are removed for communication within the main body in the lateral width direction. In this case, the upper end positions of a plurality of fins arranged within the main body are desirably lowered as they are farther laterally in both the side portions. Thus, the refrigerants evaporated within the main body gather smoothly in the central portion to flow into the upper insulating portion.

Two-piece construction is preferable in terms of working in the mechanical working of the inner fins although two-piece construction may be provided where two extruding mold materials comb-shaped in cross sectional face are spliced with each other so that respective teeth may face each other even in one-piece construction.

Aluminum means both pure aluminum and aluminum alloy.

### BRIEF DESCRIPTION OF THE DRAWINGS

Fig. 1 is a side face view for illustrating the entire construction of the cooling apparatus of the invention and the conventional cooling fin to be used for it;
Fig. 2 is a front face view showing one example of cooling fin to be used for the cooling apparatus of the invention, corresponding to an arrow view taken along a line A - A of Fig. 1;
Fig. 3 is a side face view of the cooling fin;
Fig. 4 is an arrow view taken along a line of B - B of Fig. 2;
Fig. 5 is a sectional view of an ebullition portion showing another example of the cooling fin.

### Embodiments of the Invention

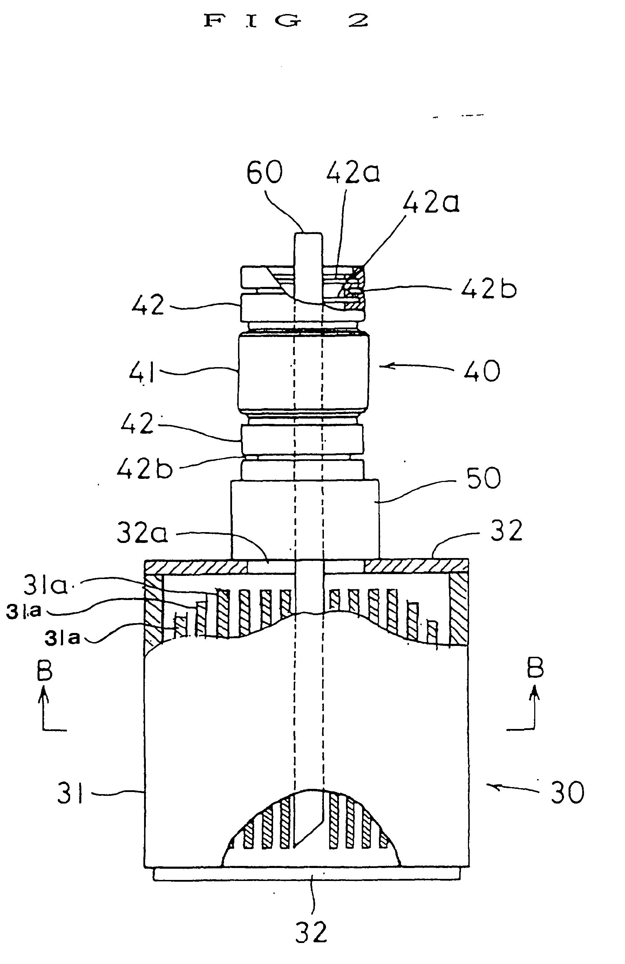

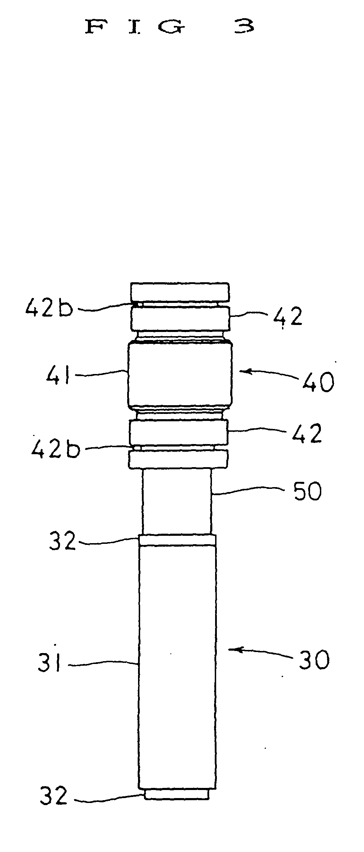

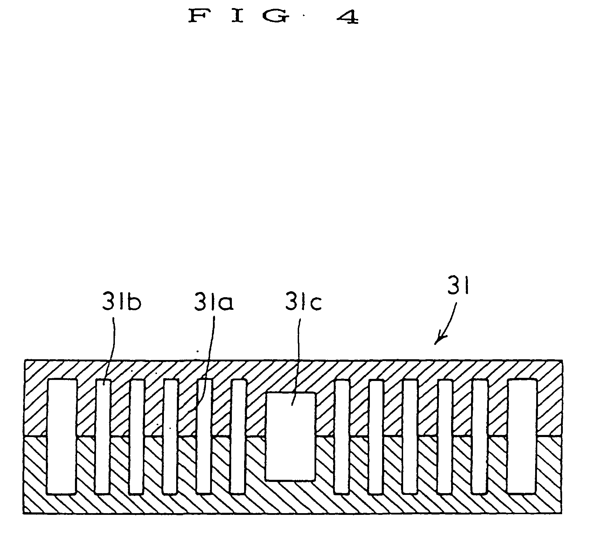

The embodiments of the invention will be described hereinafter with reference to illustrated examples. Fig. 2 is a front view showing one example of cooling-fins to be used for a cooling apparatus of the invention, corresponding to an arrow view taken along a line A - A of Fig. 1. Fig. 3 is a side view of the cooling fins. Fig. 4 is an arrow view taken along a line B - B of Fig. 2.

The basic construction of the cooling apparatus is basically same as the cooling apparatus shown in Fig. 1. Difference from the cooling apparatus shown in Fig. 1 is mainly cooling fins.

The cooling fins are provided with an ebullition portion 30 made of aluminum and an insulating portion 40 as a coupling for connecting the ebullition portion 30 to a condenser. The condenser, not shown, including a bottom portion tank for lighter weight is made of aluminum.

The ebullition portion 30 is a square box body thin in the arranging direction of the cooling fins. The box body is composed of a flat square barrel main body 31 with refrigerants flowing in a vertical direction therein and cover plates 32, 32 for closing the vertical opening portions of the main body 31.

As shown in Fig. 4, the main body 4 has a plurality of cooling passages 31b, 31b, ... formed by a plurality of fins 31a, 31a arranging in lateral direction; and a square hole 31c for allowing a return tube 60 to be inserted is provided in the central portion. The main body 31 composed of an extruding mold material is divided into two in a direction right-angled to the arranging direction of the cooling fin 2 and is integrated by soldering of each piece. Namely, two extruding mold materials with cross-sectional face being comb teeth in shape are superposed so that the respective teeth may be confronted with each other so as to compose the main body 31.

A knurling working operation for promoting the boiling is effected on the inner face of the refrigerant passage 31b within the main body 31. As shown in Fig. 2, the fins 31a, 31a, ... forming the refrigerant passages 31b, 31b, ... form some gap between the cover plates 32, 32, with the upper end portion and the lower end portion being removed, for obtaining the refrigerant flowing in the sectional width. Also, the upper end portions of the fins 31a, 31a, ... are gradually lowered as the positions become farther laterally in other side portions so that the gap on the upper side may be gradually widened in both the side portions.

The cover plates 32, 32 are spliced with the main body 31 with soldering as in each piece of the main body 31, with a flowing hole 32a of the refrigerant being provided in the cover plate 32 on the lower side.

The insulating portion 40 has aluminum tubes 42, 42 soldered in a concentric shape on the top and bottom of the ceramics tube 41. The aluminum; different from copper, can be spliced directly with ceramics with soldering. Each aluminum tube 42 has two stairs of vertical annulus grooves 42a, 42a continuous into a circumferential direction on its inner face, and one annulus groove 42b positioned between the annulus grooves 42a, 42a on its outer face. The aluminum tubes 42, 42 are flexible due to these grooves.

The aluminum tube 42 on the lower side is connected with an ebullition portion 30 through the aluminum-made connecting tube 50. The connecting tube 50 can be properly omitted. The aluminum tube 42 on the upper side is connected with an aluminum-made condenser, likewise. These connections are simply effected with TIG welding because of the connection between aluminum and aluminum.

The return tube 60, made of insulating material such as PTFE or the like, is inserted through the insulating portion 40, as before, and into the square hole 31c of the main body 31 of the ebullition portion 30. The upper end portion of the return tube 60 is coupled for its possible detachment, with pins or the like, on a cylindrical dam (see Fig. 1) provided within a tank on the bottom of the condenser.

The refrigerant liquid is flowed into the ebullition portion 30 of the cooling fins through the return tube 60 from the bottom portion tank of the condenser. The refrigerant liquid is boiled by heating of the semiconductor element provided between adjacent ebullition portions 30, 30 to cool the semiconductor element with the evaporation heat. The ebullition continues efficiently, because the fins 31a, 31a, ... are provided on the main body 31 of the ebullition portion 30. The refrigerant evaporated by the ebullition rises through the refrigerant passages 31b, 31b, ... partitioned by the fins 31a, 31a, ... within the main body, flows into the connecting tube 50 through the flowing hole 32a provided in the central portion of the cover plate 32 on the upper side, and further, returns to the bottom portion tank of the condenser through the insulating portion 40 on it. The refrigerant which is evaporated, rises within the ebullition portion gathers smoothly in the central portion so that the refrigerant rising along both the side portions is upwards discharged without staying, because the upper end positions of the fins 31a, 31a, ... are lowered on both the side portions as the they become farther laterally.

The cooling fins are light, because the ebullition portion 30 is made of aluminum. The ebullition portion 30, including the uneven inner faces of the refrigerant passage 31b, can be manufactured easily and economically by extruding. The ebullition portion is high in cooling capacity and is almost same, in thermal conduction property, as copper-made one because of the uneven inner faces by a knurling operation.

The same insulating property can be retained, because the insulating portion 40 uses a ceramics tube 41. Further, a high alloy coupling or a foreign material coupling of stainless steel aluminum used conventionally becomes needless, because aluminum tubes 42, 42 at both the ends serve as a foreign material coupling for connecting the aluminum-made condenser with the aluminum-made ebullition portion 30. The semiconductor element can be easily provided between the adjacent ebullition portions 30, 30 despite the removed stainless-made bellows, because the aluminum tubes 42, 42 are flexible due to the annulus grooves provided on the inner, outer faces. Or the weight is reduced with the removed belows.

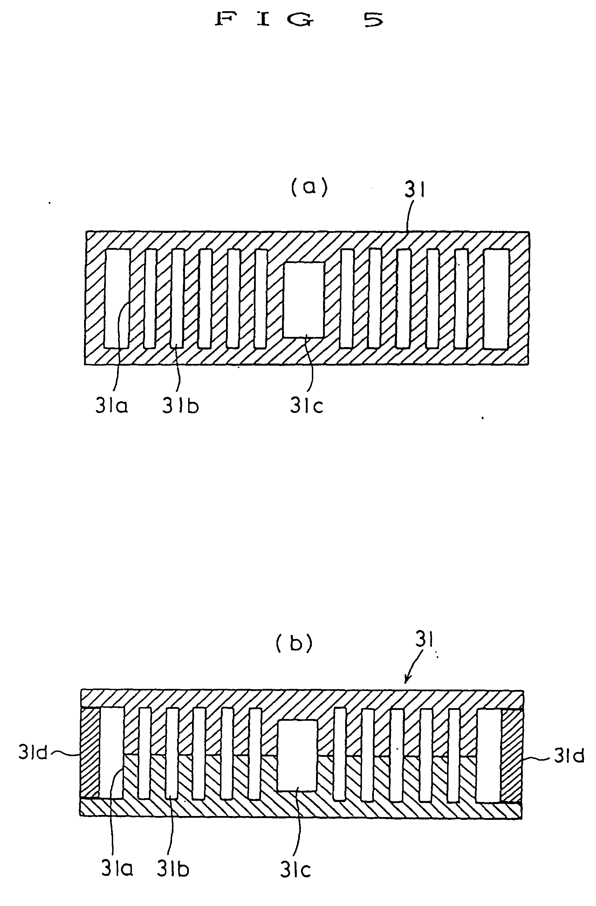

Fig. 5 is a cross-sectional view showing another construction of the ebullition portion 30. Fig 5, (A) is an ebullition portion of a complete internal empty extruding mold material without the division of the main body 31. Fig. 5, (B) is an ebullition portion where the main body 31 is divided longitudinally, and is divided with side walls of both sides as side plates 31d, 31d. Each member is an extruding mold member.

In each example, the ebullition portion 30 may be made circular as in the conventional example in Fig. 1 although it is made square in shape because of easier extruding operation.

### Effect of the Invention

As described above, the semiconductor element cooling apparatus of the invention can be considerably reduced in weight without reduction of the original performances such as cooling performance, element build-up performances and so on, because the ebullition portion of each cooling fin to be arranged in parallel on the bottom portion tank of the condenser composed of aluminum is made of aluminum, and all the materials are made of aluminum except for the ceramic tubes within the insulating portion due to connection of the foreign material coupling having aluminum tube on both the ends sides and having flexibility between the ebullition portion and the condenser. Economy is better, since the number of parts is fewer because of removing of the coupling and bellows. Further, the condenser, the insulating portion, the ebullition portion can be easily connected with TIG welding.

## Claims

1. A semiconductor element cooling apparatus of the refrigerant ebullition type, comprising:
(a) a condenser (1) having
(a1) a heat exchanger (1a), and
(a2) a tank (1b) mounted in a bottom portion downwards from the heat exchanger (1a) for storing a refrigerant liquid (11),
(b) a plurality of cooling fins (2,2) mounted at given intervals on the tank (1b) in the bottom portion of the condenser (1), whereby each of said cooling fins (2,2) is provided with
(b1) an ebullition portion (30), and
(b2) an insulating portion. (40) interposed between the ebullition portion (30) and the condenser (1), whereby through said insulating portion (40) the cooling fin (2) is communicated with a gas portion provided within the tank (1 b),
(c) a return tube (60) extending through each cooling fin (2) for introducing the refrigerant (11) from the tank (1b) into the ebullition portion (5, 30) of the cooling fin (2),
wherein heating of a semiconductor element (10) disposed between adjacent ebullition portions (30) of cooling fins (2) is robbable by boiling of refrigerant (11) feedable into the cooling fins (2) from the condenser (1) through the return tube (60), and refrigerant evaporated by the boiling is returnable to the tank (1b) in the bottom portion of the condenser (1) through the insulating portion (40) for liquefying the evaporated refrigerant,
**characterized in that**
(A) said heat exchanger, said tank, and said ebullition portion are aluminum-made; and
(B) said insulating portion (40) has
(B-1) a ceramic tube (41) and
(B-2) aluminum tubes (42, 42) being spliced directly on both ends of said ceramic tube with soldering, whereby each of said aluminum tubes has two vertical annular grooves (42a, 42a) continuous into a circumferential direction on its inner face, and one annular groove (42b) positioned between the two vertical annular grooves on its outer face to give flexibility to the aluminum tube, whereby one of said aluminum tubes (42) is joined with the aluminum-made ebullition portion (30) by welding between aluminum and aluminum, and the other aluminum tube (42) is joined with the aluminum made tank (1b) in the bottom portion of the condenser (1) by welding between aluminum and aluminum.

2. The semiconductor element cooling apparatus according to claim 1, wherein the return tube (6) is composed of an insulating material, and portions except for a ceramic tube (41) within the insulating portion of the return tube (6) and the cooling fins (2) are made of aluminum.

3. The semiconductor element cooling apparatus according to claim 1 or 2, wherein the return tube (6) is made of PTFE.

4. The semiconductor element cooling apparatus according to any one of claims 1 to 3, wherein the ebullition portion(30) is composed of:
(i) a square cylindrical main body (31) which is made of an aluminum extruding mold material, where the refrigerant (11) flows on the inner side in a vertical direction, and
(ii) upper, lower cover bodies (32) for closing the upper, lower opening portions of the main body (31),
whereby the inside of the main body (31) is partitioned into a plurality of refrigerant passages (31b, 31b, ...) with a plurality of fins (31a, 31a, ...) arranged in a lateral direction, except for at least the upper end portion and the lower end portion.

5. The semiconductor element cooling apparatus according to claim 4, wherein the main body (31) composed of aluminum extruding mold material is constructed so that two extruding mold materials comb-shaped in cross sectional face are spliced with each other so that respective teeth may face each other.

6. The semiconductor element cooling apparatus according to claim 4 or 5, wherein the upper end positions of a plurality of fins (31 a, 31a, ...) arranged within the main body (31) are lowered as they are farther laterally in both the side portions.

## Patentansprüche

1. Halbleiterelement-Kühlvorrichtung vom Kühlmittel-Siedetyp, umfassend:
(a) einen Kondensator (1), der aufweist
(a1) einen Wärmeaustauscher (1a) und
(a2) ein Gefäß (1b), das in einem Bodenteil vom Wärmeaustauscher (1a) nach unten zur Aufbewahrung einer Kühlflüssigkeit (11) montiert ist,
(b) eine Vielzahl von Kühlrippen (2,2), die in bestimmten Intervallen am Gefäß (1b) im Bodenteil des Kondensators (1) montiert sind, wobei jede der Kühlrippen (2,2) versehen ist mit
(b1) einem Siedeteil (30), und
(b2) einem zwischen dem Siedeteil (30) und dem Kondensator (1) zwischengeschalteten Isolierteil (40), wobei durch den Isolierteil (40) die Kühlrippe (2) mit einem innerhalb des Gefäßes (1b) bereitgestellten Gasteil in Kommunikation ist,
(c) ein Rückflussrohr (60), das durch jede Kühlrippe (2) verläuft, um das Kühlmittel (11) vom Gefäß (1b) in den Siedeteil (5, 30) der Kühlrippe (2) einzuführen,
worin das Erwärmen eines zwischen benachbarten Siedeteilen (30) der Kühlrippen (2) angeordneten Halbleiterelements (10) durch Kochen des in die Kühlrippen (2) vom Kondensator (1) durch das Rückflussrohr (60) einspeisbaren Kühlmittels (11) ableitbar ist, und durch das Kochen verdampftes Kühlmittel zum Gefäß (1b) im unteren Teil des Kondensators (1) durch den Isolierteil (40) zum Verflüssigen des verdampften Kühlmittels rückführbar ist,
**dadurch gekennzeichnet, dass**
(A) der Wärmeaustauscher, das Gefäß und der Siedeteil aus Aluminium bestehen; und
(B) der Isolierteil (40)
(B-1) ein Keramikrohr (41) und
(B-2) Aluminiumrohre (42, 42) aufweist, die an beiden Enden des Keramikrohrs durch Löten direkt an beide Enden des Keramikrohrs verbunden sind, wobei jedes der Aluminiumrohre zwei vertikale ringfrömige Rillen (42a, 42a) aufweist, die in Umfangsrichtung an ihrer Innenfläche kontinuierlich sind, und eine ringförmige Rille (42b), die zwischen den zwei vertikalen ringförmigen Rillen an ihrer Außenfläche positioniert ist, um dem Aluminiumrohr Flexibilität zu verleihen, wobei eines der Aluminiumrohre (42) mit dem Siedeteil (30) aus Aluminium durch Schweißung zwischen Aluminium und Aluminium verbunden ist, und das andere Aluminiumrohr (42) mit dem Gefäß (1b) aus Aluminium im unteren Teil des Kondensators (1) durch Schweißung zwischen Aluminium und Aluminium verbunden ist.

2. Halbleiterelement-Kühlvorrichtung nach Anspruch 1, worin das Rückflussrohr (6) aus einem Isoliermaterial besteht, und Teile mit Ausnahme eines Keramikrohrs (41) innerhalb des Isolieteils des Rückflussrohrs (6) und der Kühlrippen (2) aus Aluminium bestehen.

3. Halbleiterelement-Kühlvorrichtung nach Anspruch 1 oder 2, worin das Rückflussrohr (6) aus PTFE besteht.

4. Halbleiterelement-Kühlvorrichtung nach einem der Ansprüche 1 bis 3, worin der Siedeteil (30) besteht aus:
(i) einem quadratischen zylindrischen Hauptkörper (31), der aus einem Aluminium-Extrusionsformmaterial besteht, worin das Kühlmittel (11) an der Innenseite in vertikaler Richtung fließt, und
(ii) oberen, unteren Deckelkörpern (32) zum Schließen der oberen, unteren Öffnungen des Hauptkörpers (31),
wobei die Innenseite des Hauptkörpers (31) durch eine Vielzahl von in lateraler Richtung angeordneten Rippen (31 a, 31 a, ....) in eine Vielzahl von Kühlmitteldurchgängen (31b, 31b, ....) unterteilt ist, mit der Ausnahme von mindestens dem oberen Endteil und dem unteren Endteil.

5. Halbleiterelement-Kühlvorrichtung nach Anspruch 4, worin der Hauptkörper (31) aus Aluminium-Extrusionsformmaterial so konstruiert ist, dass zwei im Querschnitt kammförmige Extrusionsformmaterialien mit jedem anderen so verbunden sind, dass entsprechende Zähne einander gegenüberliegen.

6. Halbleiterelement-Kühlvorrichtung nach Anspruch 4 oder 5, worin die oberen Endteile der Vielzahl von innerhalb des Hauptkörpers (31) angeordneten Rippen (31 a, 31 a, ....) niedriger werden, je seitlicher sie in beiden Seitenteilen sind.

## Revendications

1. Appareil de refroidissement pour élément semiconducteur du type à ébullition de réfrigérant, comprenant :
(a) un condensateur (1) avec
(a1) un échangeur de chaleur (1a) et
(a2) un réservoir (1b) monté dans une partie inférieure prévue en bas de l'échangeur de chaleur (1a et destiné à stocker un liquide réfrigérant (11),
(b) plusieurs ailettes de refroidissement (2, 2) montées sur le réservoir (1b) suivant des intervalles donnés, dans la partie inférieure du condensateur (1), chacune des ailettes (2, 2) étant pourvue
(b1) d'une partie d'ébullition (30) et
(b2) d'une partie isolante (40) intercalée entre la partie d'ébullition (30) et le condensateur (1), l'ailette de refroidissement (2) communiquant grâce à la partie isolante (40) avec une partie pour gaz prévue dans le réservoir (1b),
(c) un tube de retour (60) qui traverse chaque ailette de refroidissement (2) pour introduire le réfrigérant (11) provenant du réservoir (1b) dans la partie d'ébullition (5, 30) de l'ailette (2),
étant précisé que l'échauffement d'un élément semiconducteur (10) disposé entre des parties d'ébullition voisines (30) des ailettes de refroidissement (2) peut être dissipé grâce à l'ébullition du réfrigérant (11) qui est apte à être amené dans les ailettes (2) à partir du condensateur (1) par l'intermédiaire du tube de retour (60), et le réfrigérant évaporé grâce à l'ébullition est apte à retourner dans le réservoir (1b) prévu dans la partie inférieure du condensateur (1), par l'intermédiaire de la partie isolante (40), pour liquéfier le réfrigérant évaporé,
**caractérisé en ce que**
(A) l'échangeur de chaleur, le réservoir et la partie d'ébullition sont en aluminium ; et
(B) la partie isolante (40) a
(B-1) un tube en céramique (41) et
(B-2) des tubes en aluminium (42, 42) raccordés directement aux deux extrémités du tube en céramique, par brasage, chaque tube en aluminium ayant sur son côté intérieur deux rainures annulaires verticales (42a, 42a) continues dans le sens circonférentiel, et sur son côté extérieur une rainure annulaire (42b) placée entre les deux rainures annulaires verticales pour donner une flexibilité au tube en aluminium, et l'un des tubes en aluminium (42) étant relié à la partie d'ébullition en aluminium (30), par soudage entre aluminium et aluminium, tandis que l'autre tube en aluminium (42) est relié au réservoir en aluminium (1b) prévu dans la partie inférieure du condensateur (1), par soudage entre aluminium et aluminium.

2. Appareil de refroidissement pour élément semiconducteur selon la revendication 1, dans lequel le tube de retour (6) se compose d'une matière isolante et, à l'exception d'un tube en céramique (41) prévu dans la partie isolante, des parties du tube de retour (6) et des ailettes de refroidissement (2) sont en aluminium.

3. Appareil de refroidissement pour élément semiconducteur selon la revendication 1 ou 2, dans lequel le tube de retour (6) est en PTFE.

4. Appareil de refroidissement pour élément semiconducteur selon l'une quelconque des revendications 1 à 3, dans lequel la partie d'ébullition (30) se compose :
(i) d'un corps principal cylindrique carré (31) qui est en aluminium extrudé, dans lequel le réfrigérant (11) coule sur le côté intérieur dans un sens vertical, et
(ii) de corps formant couvercles supérieur et inférieur (32) pour fermer les parties d'ouverture supérieure et inférieur du corps principal (31),
l'intérieur du corps principal (31) étant divisé en plusieurs passages pour réfrigérant (31b, 31b,...) grâce à plusieurs ailettes (31a, 31a,....) disposées dans un sens latéral, sauf au moins la partie d'extrémité supérieure et la partie d'extrémité inférieure.

5. Appareil de refroidissement pour élément semiconducteur selon la revendication 4, dans lequel le corps principal (31) en aluminium extrudé est construit pour que deux matériaux extrudés en forme de peignes, en coupe transversale, soient raccordés de telle sorte que leurs dents puissent se faire face.

6. Appareil de refroidissement pour élément semiconducteur selon la revendication 4 ou 5, dans lequel les extrémités supérieures de plusieurs ailettes (31a, 31a,...) disposées dans le corps principal (31) sont situées de plus en plus bas sur les côtés, dans les deux parties latérales.
